# FASCICULE DE BREVET EUROPEEN

(11) **EP 3 531 142 B1**
(45) Date de publication et mention de la délivrance du brevet: **26.02.2020**
(21) Numéro de dépôt: 19154069.9
(22) Date de dépôt: 29.01.2019
(51) Int. Cl.: G01R 22/06

(54) **DISPOSITIF DE MESURE D'AU MOINS UNE GRANDEUR ELECTRIQUE D'UN COURANT CIRCULANT DANS AU MOINS UN APPAREIL ELECTRIQUE**
VORRICHTUNG ZUM MESSEN MINDESTENS EINER ELEKTRISCHEN GRÖSSE EINES STROMS, DER IN MINDESTENS EINEM ELEKTRISCHEN GERÄT FLIESST
DEVICE FOR MEASURING AT LEAST ONE ELECTRICAL MAGNITUDE OF A CURRENT CIRCULATING IN AT LEAST ONE ELECTRICAL APPARATUS

(30) Priorité: 27.02.2018 FR 1851687
(43) Date de publication de la demande: 28.08.2019
(73) Titulaire: Schneider Electric Industries SAS, 92500 Rueil Malmaison (FR)
(72) Inventeur: CHANSAVANG, Albert, 38050 GRENOBLE (FR); AMBLARD, Jean-Yves, 38050 GRENOBLE (FR)
(74) Mandataire: Tripodi, Paul

(56) Documents cités:
- EP-A1- 1 736 784
- EP-A2- 2 592 390
- FR-A1- 2 998 674
- US-A1- 2001 043 062

## Description

### DOMAINE TECHNIQUE

La présente invention concerne un dispositif de mesure d'au moins une grandeur électrique d'un courant circulant dans au moins un appareil électrique monté sur un support de montage, comportant des moyens d'alimentation électrique, des moyens de mesure du courant circulant dans l'appareil, des moyens de prise de la tension aux bornes de l'appareil, et des moyens de mesure de cette tension, des moyens de traitement de l'information de mesure, et des moyens de communication des informations de mesure à un récepteur.

### ETAT DE LA TECHNIQUE

On connaît un dispositif de mesure de l'énergie traversant un appareil électrique réalisé par plusieurs dispositifs séparés réalisant respectivement la fonction de communication, le traitement de données, la mesure de tension, la mesure de courant, cette réalisation en plusieurs dispositifs séparés rendant l'installation coûteuse, volumineuse et complexe, bien que permettant une adaptation à n'importe quel produit ou configuration.

On connaît également un dispositif de mesure et de communication réalisé par l'intermédiaire d'un module complètement intégré, rendant l'installation simple et compacte. Cependant, ce dispositif est seulement adapté à une configuration de bornes données, et la précision de mesure est faible.

On connaît également des dispositifs de mesure procurant une performance de mesure élevée dans un produit compact. Mais ces produits ne s'adaptent pas à tout type de configuration de bornes des produits sans qu'il soit nécessaire de réaliser des modifications sur ce produit.

Les documents EP 2 592 390 A2, FR 2 998 674 A1 et US 2001/043062 A1 divulguent des dispositifs de mesure de l'art antérieur.

La présente invention résout ces problèmes et propose un dispositif de mesure d'au moins une grandeur électrique d'un courant circulant dans au moins un appareil électrique, ce dispositif, outre le fait qu'il présente une certaine compacité et une bonne performance de mesure, offre en plus une adaptabilité améliorée aux différentes configurations de bornes des appareils et ainsi une plus grande flexibilité lors de son installation.

### EXPOSE DE L'INVENTION

A cet effet, la présente invention a pour objet un dispositif de mesure d'au moins une grandeur électrique d'un courant circulant dans au moins un appareil électrique, ce dispositif étant caractérisé en ce qu'il comporte un premier module, dit principal, comprenant les moyens d'alimentation, les moyens de mesure du courant et de la tension, les moyens de traitement et les moyens de communication précités, et un second module dit auxiliaire comportant les moyens de prise de tension et des moyens de connexion électrique avec le module dit principal, cette connexion permettant l'alimentation en tension du module principal et la mesure de la tension relevée par le module auxiliaire, le second module comportant des moyens de raccordement électrique aux bornes de l'appareil à mesurer, ces moyens étant adaptés à la configuration de ces bornes.

Selon une caractéristique particulière, les moyens de communication précités sont des moyens de communication sans fil.

Selon une autre caractéristique, les moyens de connexion précités comportent des plots électriques prévus sur les deux faces de raccordement en regard l'une par rapport à l'autre appartenant respectivement aux deux modules.

Selon une autre réalisation, les moyens de connexion électriques précités sont du type permettant aux deux modules d'être utilisés en étant éloignés l'un par rapport à l'autre.

Selon une autre caractéristique, ces moyens de connexion comportent des câbles électriques.

Selon une autre caractéristique, ce dispositif comporte des moyens d'identification des deux modules, la combinaison des moyens d'identification des deux modules permettant de réaliser la configuration du produit constitué par l'association des deux modules.

Selon une autre caractéristique, ces moyens d'identification comportent des plots électriques prévus sur les deux faces en regard appartenant respectivement aux deux modules, ces plots étant connectés à un bus de communication permettant l'envoi d'une trame d'identification permettant la configuration entre les deux modules.

Selon une autre réalisation, ces moyens d'identification comportent des moyens de liaison RF ou optiques entre les deux modules permettant l'envoi d'une trame d'identification permettant la configuration entre les deux modules.

Selon une autre caractéristique, le module principal est identifié par l'une des caractéristiques comprises dans le groupe comprenant le type de phase, le calibre, la forme du produit.

Selon une autre caractéristique, le module auxiliaire est identifié par son usage.

Selon une autre caractéristique, le module auxiliaire précité comporte des moyens de guidage de câbles permettant de faciliter le positionnement de ces câbles à l'intérieur dudit module auxiliaire, ces câbles véhiculant le courant dans l'appareil à mesurer.

Selon une autre caractéristique, le module auxiliaire précité comporte des moyens d'indication de l'état de service du dispositif de mesure.

Selon une autre caractéristique, le module auxiliaire comporte des contacts électriques montés en translation et/ou en rotation par rapport audit module auxiliaire de manière à s'adapter à différentes configurations de bornes de l'appareil à mesurer.

Selon une réalisation particulière, les moyens de raccordement précités comportent des éléments rigides aptes à être raccordés électriquement aux bornes de l'appareil à mesurer en un seul mouvement.

Selon une autre réalisation, les moyens de raccordement précités comportent des câbles de raccordement aux bornes de l'appareil à mesurer.

Selon une autre réalisation, le module auxiliaire précité est utilisé comme un module additionnel monté sur un dispositif de mesure du type monobloc classique, lequel est utilisé comme un module dit principal.

Selon une autre réalisation, le module principal est équipé de bornes de raccordement adaptées à la configuration du tableau électrique dans lequel le dispositif de mesure de l'énergie est destiné à être monté.

Selon une caractéristique particulière, ce dispositif comporte des moyens de codage prévus entre les deux modules permettant d'empêcher les mauvaises associations entre les deux modules.

Selon une autre caractéristique, ce dispositif comporte un micrologiciel permettant d'établir le comportement correspondant à la configuration du produit constitué par l'association des deux modules.

Selon une autre caractéristique, le premier module est placé derrière le rail oubien à l'intérieur d'un conduit de câbles latéral oubien à l'intérieur d'un conduit de câbles horizontal.

Selon une autre caractéristique, le module auxiliaire se présente sous la forme d'une plaque dite d'adaptation comportant des moyens de raccordement adaptés aux bornes de raccordement de l'appareil à mesurer.

Avantageusement, l'appareil est un appareil de protection électrique.

Selon une caractéristique particulière, ce dispositif est un dispositif de mesure de l'énergie traversant au moins un appareil électrique.

### ENONCE DES FIGURES

Mais d'autres avantages et caractéristiques de l'invention apparaîtront mieux dans la description détaillée qui suit et se réfère aux dessins annexés donnés uniquement à titre d'exemple et dans lesquels :
- La figure 1 est une vue en perspective, illustrant un dispositif de mesure d'énergie selon l'art antérieur, ainsi que deux modes de réalisation d'un dispositif de mesure d'énergie selon l'invention,
- La figure 2 est une vue partielle en perspective, illustrant le montage d'un dispositif de mesure d'énergie selon l'invention sur un appareil électrique,
- La figure 3 est une vue en perspective, illustrant ce même dispositif de mesure en position de mise en service sur l'appareil électrique précité,
- La figure 4 est une vue partielle en perspective, illustrant ce même dispositif de mesure mis en service sur un appareil électrique monté sur un rail de montage,
- La figure 5 est une vue en perspective, illustrant une réalisation particulière du dispositif de mesure selon l'invention comportant un moyen de signalisation de l'état du dispositif,
- La figure 6 est une vue en perspective, illustrant ce même dispositif selon une autre réalisation du dispositif comportant des contacts électriques coulissants et rotatifs,
- La figure 7 est une vue en perspective, illustrant une autre réalisation de ce dispositif,
- La figure 8 est une vue en perspective d'une autre réalisation de l'invention dans laquelle seule une partie de ce dispositif de mesure est utilisée, en combinaison avec un dispositif de mesure selon l'art antérieur,
- La figure 9 est une vue en perspective, illustrant une autre réalisation de l'invention dans laquelle le dispositif comporte des bornes de raccordement,
- La figure 10 est une vue en perspective, illustrant quatre modes de réalisation différents du dispositif de mesure selon l'invention, correspondant respectivement à quatre utilisations différentes de ce dispositif,
- La figure 11 est une vue en perspective, illustrant plus particulièrement les deux faces en regard de deux modules constituant un dispositif de mesure selon une réalisation particulière de l'invention,
- La figure 12 est une vue en perspective, illustrant quatre réalisations différentes de la première partie du dispositif de mesure d'énergie selon l'invention, et
- Les figures 13 et 14 illustrent huit modes de réalisation différents du dispositif selon l'invention, respectivement avant et après l'association des deux modules composant le dispositif.

### EXPOSE DETAILLE DE MODES DE REALISATION PARTICULIERS

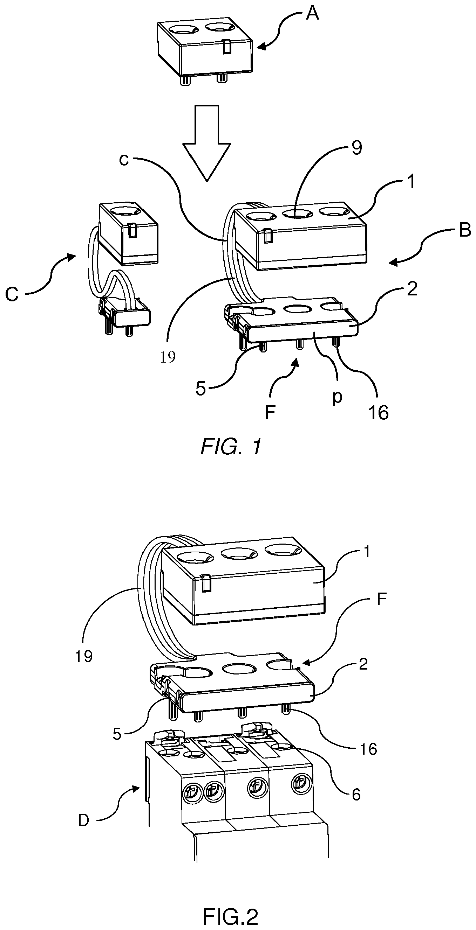

Sur la figure 1, on voit trois dispositifs de mesure de l'énergie électrique A,B,C, chaque dispositif étant destiné à être associé à un appareil électrique tel un appareil de protection électrique D, par exemple un disjoncteur, monté sur un support de montage, afin de mesurer l'énergie électrique traversant ledit appareil. Le premier A de ces dispositifs est un dispositif de mesure de l'énergie selon l'art antérieur et est logé dans un boîtier monobloc.

Le second B et le troisième C de ces dispositifs de mesure sont des dispositifs de mesure de l'énergie selon l'invention.

Selon l'invention, le dispositif de mesure de l'énergie comporte deux modules séparés 1,2 destinés à être associés l'un à l'autre et reliés électriquement l'un à l'autre. Le premier 1 de ces modules, dit module principal, comporte des moyens d'alimentation électrique, des moyens de mesure du courant, des moyens de traitement de données, des moyens de communication sans fil, par exemple du type RF Zigbee. Les moyens d'alimentation désignent la fonction électronique assurant l'alimentation dans le module principal. Des câbles 4 traversent le module principal 1 et sont destinés à véhiculer le courant dans l'appareil à mesurer, par exemple un disjoncteur.

Le second 2 de ces modules, dit module auxiliaire, comporte des moyens dits de prise de tension p, destinés à prendre la tension aux bornes, par exemple les bornes amont 6 de l'appareil à mesurer D, et des moyens c pour relier électriquement ledit module auxiliaire 2 au module dit principal 1 afin d'alimenter ce dernier en tension et de réaliser la mesure de cette tension, puis la communication de l'information de mesure de cette tension et de mesure du courant, à un dispositif extérieur.

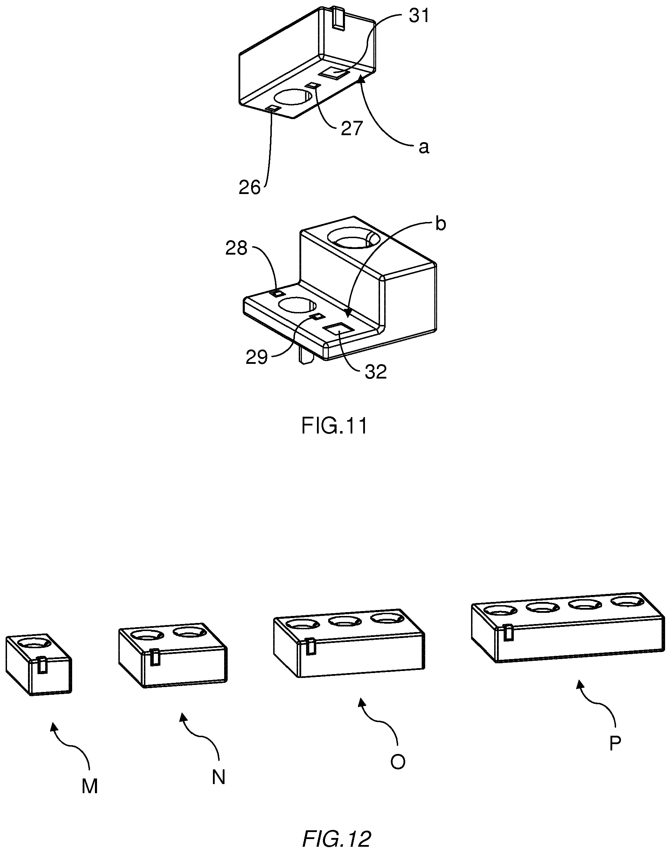

Afin de rendre le fonctionnement de cette association de modules possible, deux fonctions sont nécessaires, tel que ceci est particulièrement illustré sur la figure 11. La première de ces fonctions est d'assurer la connexion électrique entre ces deux modules 1,2 de manière à permettre au module principal 1 de mesurer la tension relevée par le module auxiliaire 2. La seconde 2 de ces fonctions est de configurer ces deux modules 1,2 l'un par rapport à l'autre par l'intermédiaire de moyens d'identification 31,32 prévus entre les deux modules, ces moyens permettant de déterminer pour les deux modules par exemple, le nombre de phases, les valeurs du courant et de la tension maximum, le type de boîtier, etc...

Ces moyens d'identification 31,32 peuvent être réalisés de différentes manières. L'une de ces manières peut consister à prévoir des plots électriques sur les deux faces en regard a,b des deux modules, ces plots étant connectés ou non à une grandeur électrique fixe permettant par exemple de générer un code binaire. Par exemple, deux plots sur chaque module permettent d'obtenir quatre codes différents et donc quatre configurations différentes.

Une autre solution peut consister à prévoir des plots électriques 31,32 connectés à un bus de communication permettant l'envoi d'une trame d'identification permettant la configuration entre les deux modules. Une autre solution pourrait consister à prévoir la présence d'une liaison RF ou optique entre les deux modules 1,2 permettant l'envoi d'une trame d'identification permettant la configuration entre les deux modules.

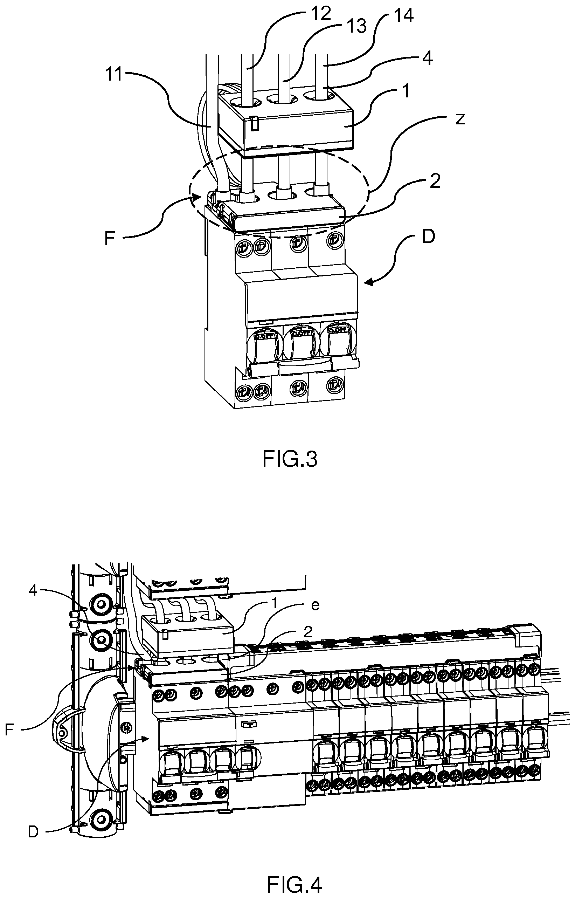

Tel qu'illustré sur les figures, et plus particulièrement les figures 3 et 4, le module dit principal 1 comporte des orifices 9 destinés à permettre le passage des conducteurs de puissance 4. Ces conducteurs comprenent un conducteur de neutre 11 et trois conducteurs de phase 12,13,14, et sont destinés à être reliés par l'une de leurs extrémités, à une source d'alimentation électrique, et par leur extrémité opposée, respectivement, à des contacts électriques 16 formés par des broches appartenant au second module 2. Ces contacts électriques 16, ou bornes 16, sont destinés à être reliés électriquement respectivement aux différentes bornes de raccordement 6 appartenant à l'appareil électrique D.

Selon la réalisation de l'invention décrite sur la figure 2, ces broches 16 sont aptes à être introduites respectivement dans les bornes 6 de l'appareil à mesurer D, la manœuvre s'effectuant en un seul mouvement.

Selon l'invention, le second module 2 est choisi de manière à s'adapter à la configuration et en particulier à la configuration des bornes 6 de l'appareil D à mesurer. Ce second module 2 se présente avantageusement sous la forme d'une plaque F, dite plaque d'adaptation, de petite dimension, apte à être superposée à la face de raccordement de l'appareil à mesurer D. Cette possibilité de séparer les deux modules permet avantageusement de libérer un espace e entre le premier module 1 et le second module 2, cet espace permettant d'offrir une bonne visibilité par rapport à la zone de connexion z de l'appareil à mesurer et une bonne accessibilité à cette zone lors du raccordement des câbles de puissance 4 à l'appareil à mesurer D.

On notera que les deux modules 1,2 ne sont pas nécessairement localisés au même endroit autour de l'appareil mesuré D. Si le module auxiliaire 2 est toujours de manière évidente relié à l'appareil mesuré D, le module principal 1 peut être déplacé d'une certaine distance, en fonction de la longueur de câble entre les deux modules, par rapport au premier module en un endroit où il y a plus d'espace disponible, par exemple derrière un rail DIN, à l'intérieur d'une conduite de câbles latérale, à l'intérieur d'une conduite de câbles horizontale, etc...

Il y a ainsi plus d'espace autour de l'appareil mesuré pour faciliter le raccordement.

Dans certaines configurations de tableau peu volumineuses, présentant une petite distance inter-rails, une densité importante de fils, l'invention peut rendre l'installation d'un dispositif de mesure de l'énergie B,C possible en des endroits où cela ne l'était pas auparavant.

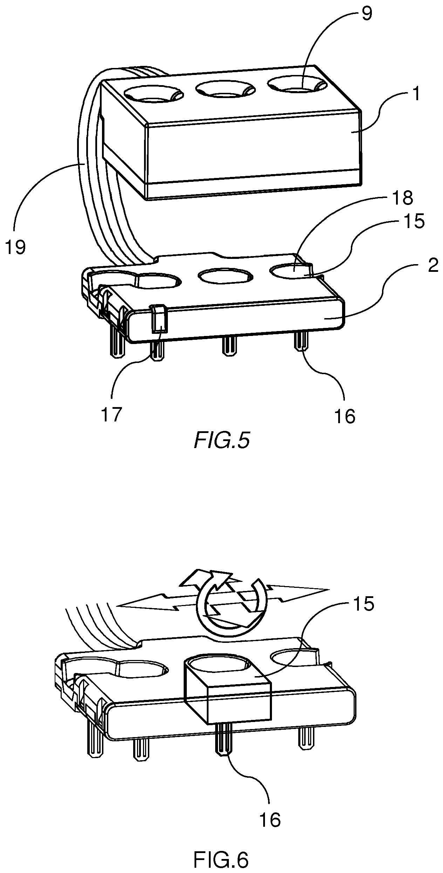

Avantageusement, tel qu'illustré sur la figure 5, la plaque d'adaptation F est équipée d'une LED 17 destinée à donner l'information de l'état en service ou hors service du dispositif de mesure ou autres informations codées sous forme de clignotements ou couleurs différentes. Ceci permet d'assurer que l'information lumineuse est toujours visible peu importe où est situé le module principal 1 à l'intérieur du tableau.

Tel qu'illustré sur les figures 3 à 5, ce second module 2 présente avantageusement des moyens de guidage 18 des câbles de puissance 4, ces moyens étant formés par les parois des ouvertures prévues dans le module auxiliaire 2 pour recevoir les câbles 4 et menant aux contacts électriques 16 du module 2.

Ainsi, la présence de la plaque d'adaptation F ne nuit pas à l'ergonomie du raccordement de l'appareil mesuré D. Aucune préparation particulière des fils n'est nécessaire pour l'introduction de ces câbles 4 dans les ouvertures 9. Avantageusement, la connexion électrique entre le module principal 1 et le module auxiliaire 2 est réalisée par des câbles 19. Ces câbles 19 peuvent être rond ou bien plat, un câble plat étant plus facile à manipuler.

Avantageusement, tel qu'illustré sur la figure 6, le module auxiliaire 15 est tel que chaque contact électrique 16 de cette plaque d'adaptation F est apte à être déplacé en translation ou en rotation par rapport à la plaque F de manière à s'adapter à différentes configurations de bornes de raccordement 6 de l'appareil D.

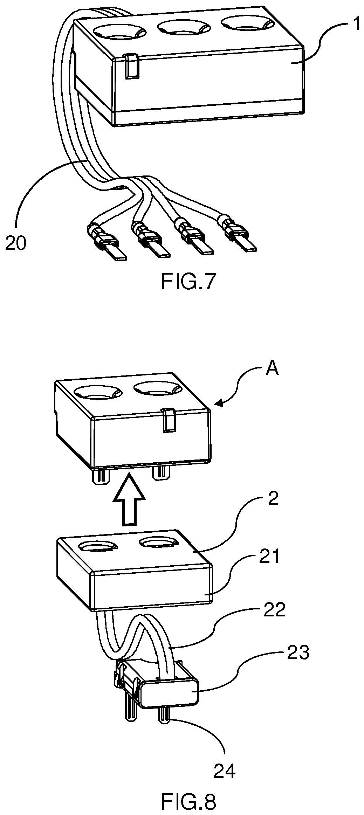

Selon la réalisation illustrée sur la figure 7, les deux modules respectivement principal 1 et auxiliaire 2 n'en forment qu'un seul, et les moyens de raccordement électriques 5 du module auxiliaire 2 aux bornes 6 de l'appareil D sont des câbles 20.

Ainsi, même si cette solution requiert davantage de manœuvres de raccordement, elle permet de s'adapter à toutes les configurations.

L'extrémité des fils peut ainsi être laissée sans aucune préparation particulière, laissant à l'installateur le soin de l'équiper si nécessaire, ou bien être équipée d'un conducteur plat par exemple pour un raccordement plus aisé à l'intérieur d'une borne à vis.

Sur la figure 8, un module d'alimentation en tension 2 ou module auxiliaire selon l'invention est conçu comme un module additionnel 21 destiné à être associé à un dispositif de mesure de l'énergie selon l'art antérieur A, ledit module d'alimentation en tension 2 étant relié électriquement à l'appareil à mesurer D par des câbles 22 eux-mêmes reliés électriquement par l'une de leurs extrémités au module auxiliaire 2, et par leur extrémité opposée, à un accessoire 23 comportant des broches 24 de raccordement électrique aux bornes 6 de l'appareil D.

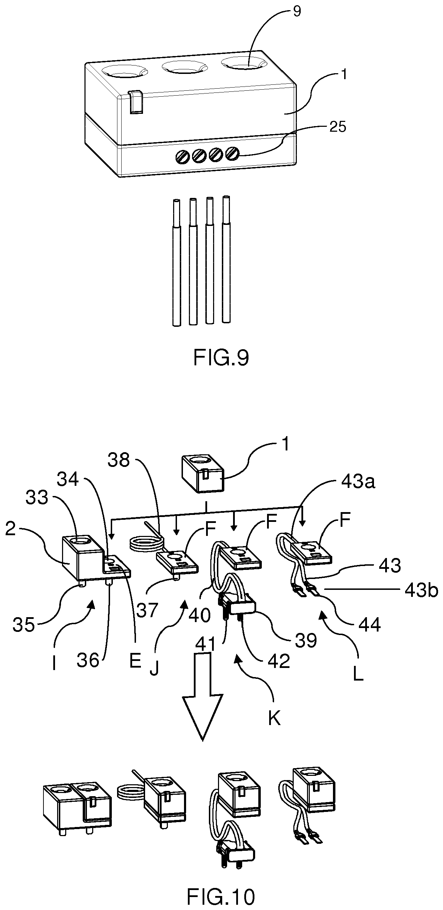

Selon la réalisation illustrée sur la figure 9 dans laquelle les deux modules respectivement principal 1 et auxiliaire 2 n'en forment qu'un seul, le module principal 1 comporte des bornes de raccordement 25 destinées à recevoir l'une des extrémités de fils préparées par l'installateur lui-même. Ces extrémités de fil peuvent être préparées de manière à s'adapter à la configuration de raccordement du tableau électrique dans lequel l'appareil est destiné à être monté, le raccordement proposé pouvant par exemple être du type prévu pour recevoir une partie d'extrémité sans partie isolante, un conducteur plat ou du type à connexion rapide.

La figure 10 est une vue en perspective illustrant quatre modes de réalisation différents d'un dispositif de mesure d'énergie selon l'invention.

Dans tous ces modes de réalisation, le module principal 1 est du type une phase ou une phase plus neutre, et est relié électriquement au module auxiliaire 2 par l'intermédiaire de deux contacts électriques 26,27 prévus sur la face de raccordement du module principal 1, aptes à être amenés en contact respectivement avec deux contacts électriques 28,29 prévus sur la face de raccordement du module auxiliaire 2, tel qu'illustré sur la figure 11. Cette figure 11 illustre également les moyens d'identification entre les deux modules 1,2 permettant la configuration entre les deux modules, ces moyens étant constitués également, dans cette réalisation particulière, par l'intermédiaire de plots électriques 31,32.

La connexion électrique entre le module principal 1 et le module auxiliaire 2 permet l'alimentation en tension du module auxiliaire 2 et ainsi la mesure de la tension prise aux bornes 6 de l'appareil à mesurer D.

La configuration du produit après association des deux modules 1,2 est réalisée après l'identification des deux modules 1,2. Le module principal est identifié par exemple par son nombre de phase, son calibre, sa forme, par exemple respectivement, 1 phase/1 phase plus neutre ; 63A max, 18mm.

Le module auxiliaire est identifié par exemple par son usage, par exemple pour un disjoncteur unipolaire.

La configuration de produit est réalisée par la combinaison des données d'identification des deux modules. Cette combinaison de données peut être simple, telle que lorsqu'il s'agit d'appareils électriques de protection alignés mécaniquement, ou plus complexe, lorsque les appareils à mesurer sont du type comportant un bus de communication, NFC/RFID par exemple.....

Des moyens de codage (non représentés) peuvent être prévus en partie sur le module principal 1 et en partie sur le module auxiliaire 2 de manière à empêcher une association non souhaitée.

Cette configuration de produit une fois réalisée permet à un micrologiciel d'établir le comportement correspondant à la configuration de produit construit.

Sur cette figure 10, selon la première réalisation I, le module auxiliaire 2 est du type bipolaire et comporte deux ouvertures 33,34 aptes à recevoir respectivement deux parties d'extrémité appartenant respectivement à deux conducteurs de puissance, de manière à permettre la prise de tension sur deux bornes de l'appareil à mesurer, le raccordement électrique avec l'appareil à mesurer s'effectuant au moyen de deux broches 35,36 appartenant au module auxiliaire 2 destinées à coopérer avec les bornes 6 de l'appareil D. Cependant, le boîtier de ce module auxiliaire présente deux parties de dimensions différentes de manière à présenter un emplacement E apte à recevoir le module principal 1 de telle manière que l'ensemble des deux boîtiers réunis présente une forme sensiblement parallélépipédique. Ainsi, dans ce type d'appareil, la prise de tension est réalisée sur les deux bornes de l'appareil par l'intermédiaire des deux broches, tandis que la mesure du courant n'est réalisée qu'au niveau d'une seule des bornes de l'appareil, le module principal 1 ne comportant qu'une ouverture pour le passage d'un conducteur.

Selon la seconde réalisation de l'invention J, le module auxiliaire 2 présente une forme de plaque F comportant une broche de raccordement 37 à une borne d'un appareil, ainsi qu'un conducteur 38 destiné à être relié électriquement au neutre. Selon la troisième réalisation K, le module auxiliaire se présente sous la forme d'une plaque d'adaptation F relié électriquement à un accessoire de raccordement 39 par l'intermédiaire d'un câble 40, cet accessoire 39 comportant deux broches 41,42 de raccordement respectivement à deux bornes appartenant à un appareil à mesurer. Ainsi, dans cette réalisation, la prise de tension est réalisée sur les deux bornes de l'appareil, alors que la mesure du courant n'est réalisée que sur un seul conducteur de puissance.

Selon la quatrième réalisation, le module auxiliaire 2 comporte une plaque d'adaptation F destinée à être reliée électriquement par l'intermédiaire de câbles 43 à l'appareil à mesurer, ces câbles 43 comportant une extrémité 43a intégrée au module auxiliaire et une extrémité opposée 43b comportant des fiches 44 destinées à être introduites dans les bornes de l'appareil.

Sur la figure 11, tel qu'indiqué précédemment, les contacts électriques 26,27 et 28,29 entre le module principal 1 et le module auxiliaire 2 permettent à la fois l'alimentation en tension du module auxiliaire 2 et la mesure de la tension aux bornes 6 de l'appareil à mesurer D.

La figure 12 illustre quatre réalisations différentes M,N,O,P du module dit principal 1 correspondant respectivement à un module du type unipolaire ou unipolaire et neutre M, à un module bipolaire N, à un module tripolaire, ou tripolaire et neutre O, et à un module tétra polaire P.

Les calibres pour ces quatre réalisations seront respectivement par exemple : 1-25A ; 10-63A ; 40-100A ; 100-250A.

Les pas pour ces différents modules seront respectivement par exemple de 9mm, 18mm, 27mm, et 36mm.

On notera que les deux modules 1,2 peuvent être manipulés séparément, compte-tenu du fait qu'ils sont logés dans un contenant fermé, et sont faciles à assembler.

L'assemblage des deux modules peut être verrouillé afin d'éviter que le consommateur ne détruise cet assemblage.

On notera également que les modules auxiliaires peuvent être classés en fonction de leurs utilisations. A partir d'un seul module principal, peuvent être dérivés un grand nombre de configurations de produits.

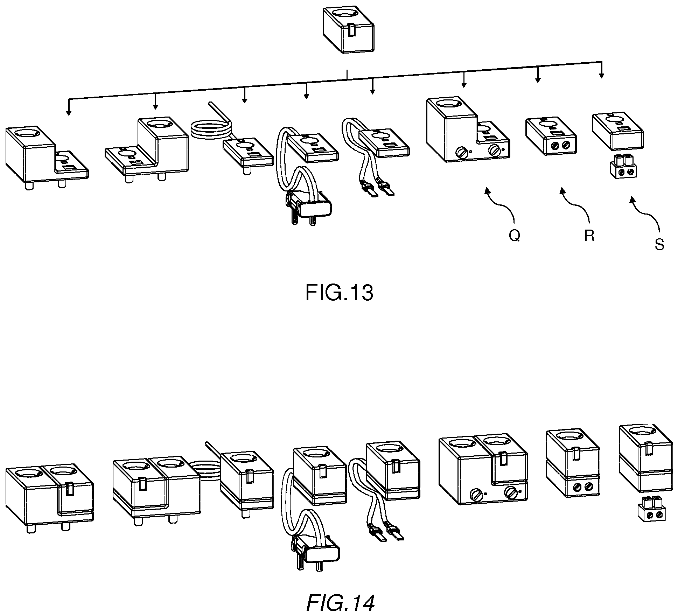

Les figures 13 et 14 illustrent dans des vues en perspective, plusieurs modes de réalisation du dispositif de mesure de l'énergie respectivement avant et après l'association des deux modules, ces figures représentant plusieurs réalisations Q,R,S non décrites dans la figure 10, dans lesquelles le module auxiliaire 2 comporte des moyens de raccordement indépendants de l'appareil à mesurer, par exemple du type à connexion par perforation d'isolant dans le câble de puissance, ou du type utilisant un bornier déconnectable.

On a donc réalisé grâce à l'invention, un dispositif de mesure de l'énergie électrique présentant une visibilité et une accessibilité améliorée lors du raccordement électrique de l'appareil électrique, de manière à ne pas nuire à l'ergonomie liée au raccordement de l'appareil à mesurer.

Ceci est rendu possible par le fait que ce dispositif se présente sous la forme d'un produit en deux modules séparés, respectivement un module principal et un module auxiliaire, dit aussi module d'alimentation en tension.

Ces deux modules sont par exemple connectés électriquement l'un à l'autre par des plots électriques situés sur leurs faces de raccordement, oubien reliés électriquement par des câbles, lesquels pouvant par exemple être du type rond ou plat.

Ce module auxiliaire est de dimension suffisamment réduite pour améliorer la visibilité et l'accessibilité des bornes de raccordement de l'appareil mesuré.

Le fait que les deux modules puissent être connectés électriquement en étant éloignés l'un de l'autre, grâce à tout type de connexion électrique le permettant, telle une connexion par câble ou plot, permet d'augmenter cette visibilité et cette accessibilité. Ces plots ou câbles sont connectés aux modules par exemple par soudure, sertissage, vissage ou embrochage.

L'ergonomie précitée est encore améliorée par la possibilité de prévoir des éléments de guidage sur la plaque d'adaptation.

Ce dispositif de mesure de l'énergie selon l'invention, permet également d'augmenter considérablement l'adaptabilité aux appareils à mesurer par le fait que le module auxiliaire est conçu sous la forme d'une plaque dite d'adaptation apte à s'adapter à la configuration des bornes de raccordement de l'appareil à mesurer, ceci permettant d'augmenter la modularité du dispositif. Avantageusement, le positionnement des connexions électriques entre le module auxiliaire et l'appareil à mesurer s'effectue en un seul mouvement par l'intermédiaire de broches appartenant au module auxiliaire aptes à coopérer avec les bornes de l'appareil à mesurer.

Ainsi, grâce à l'invention, l'adaptation à un appareil à mesurer particulier requiert le choix d'un module auxiliaire adapté, le module principal restant inchangé. Il n'est donc plus nécessaire de réaliser un dispositif de mesure complet spécifique, seul le module auxiliaire nécessite d'être spécifique.

Un autre avantage présenté par ce dispositif de mesure selon l'invention tient en ce qu'il n'est plus nécessaire de préparer les extrémités de câble, comme ceci est le cas pour le dispositif de l'art antérieur nécessitant de prévoir par exemple une longueur de fil plus importante, ou bien un embout sans anneau isolant.

Ainsi, différents modules auxiliaires peuvent être associés à un module principal afin de créer un dispositif spécialement adapté à un besoin spécifique.

Cette polyvalence permet au dispositif d'être utilisé pour des utilisations multiples et des environnements différents. L'association de modules peut être réalisée par le consommateur et/ou sur la ligne de fabrication.

La présente invention permet une différenciation retardée industrielle ou par rapport au client.

L'invention permet donc d'apporter une simplification par rapport à la complexité due au grand nombre de produits et configurations de bornes aux quels le dispositif de mesure doit s'adapter.

Bien entendu, l'invention n'est pas limitée aux modes de réalisation décrits et illustrés qui n'ont été donnés qu'à titre d'exemple.

L'invention est définie par les revendications suivantes.

## Revendications

1. Dispositif de mesure d'au moins une grandeur électrique d'un courant circulant dans au moins un appareil électrique monté sur un support de montage, comportant des moyens d'alimentation électrique, des moyens de mesure du courant circulant dans l'appareil, des moyens de prise de la tension aux bornes de l'appareil, et des moyens de mesure de cette tension, des moyens de traitement de l'information de mesure, et des moyens de communication des informations de mesure à un récepteur, **caractérisé en ce qu'**il comporte un premier module (1), dit principal, comprenant les moyens d'alimentation, les moyens de mesure du courant et de la tension, les moyens de traitement et les moyens de communication précités, et un second module dit auxiliaire (2) comportant les moyens de prise de tension (p) et des moyens de connexion électrique (c) avec le module dit principal (1), cette connexion permettant l'alimentation en tension du module principal (1) et la mesure de la tension relevée par le module auxiliaire (2), le second module (2) comportant des moyens de raccordement électrique (5) aux bornes (6) de l'appareil à mesurer (D), ces moyens (5) étant adaptés à la configuration de ces bornes (6).

2. Dispositif de mesure d'au moins une grandeur électrique selon la revendication 1, dans lequel les moyens de communication précités sont des moyens de communication sans fil.

3. Dispositif de mesure d'au moins une grandeur électrique selon la revendication 1 ou 2, dans lequel les moyens de connexion précités (c) comportent des plots électriques (26,27) et (28,29) prévus sur les deux faces de raccordement en regard (a,b) l'une par rapport à l'autre appartenant respectivement aux deux modules (1,2).

4. Dispositif de mesure d'au moins une grandeur électrique selon la revendication 1 ou 2, dans lequel les moyens de connexion électriques précités (c) sont du type permettant aux deux modules (1,2) d'être utilisés en étant éloignés l'un par rapport à l'autre.

5. Dispositif de mesure d'au moins une grandeur électrique selon la revendiation 4, dans lequel les moyens de connexion précités (c) comportent des câbles électriques (19).

6. Dispositif de mesure d'au moins une grandeur électrique selon l'une quelconque des revendications 1 à 5, comportant des moyens d'identification (31, 32) des deux modules (1,2), la combinaison des moyens d'identification (31, 32) des deux modules (1,2) permettant de réaliser la configuration du produit constitué par l'association des deux modules (1,2).

7. Dispositif de mesure d'au moins une grandeur électrique selon la revendication 6, dans lequel les moyens d'identification (31,32) comportent des plots électriques prévus sur les deux faces (a,b) en regard appartenant respectivement aux deux modules (1,2), ces plots étant connectés à un bus de communication permettant l'envoi d'une trame d'identification permettant la configuration entre les deux modules.

8. Dispositif de mesure d'au moins une grandeur électrique selon la revendication 6, dans lequel les moyens d'identification (31, 32) comportent des moyens de liaison RF ou optiques entre les deux modules (1,2) permettant l'envoi d'une trame d'identification permettant la configuration entre les deux modules (1,2).

9. Dispositif de mesure d'au moins une grandeur électrique selon l'une quelconque des revendications 6 à 8, dans lequel le module principal (1) est identifié par l'une des caractéristiques comprises dans le groupe comprenant le type de phase, le calibre, la forme du produit.

10. Dispositif de mesure d'au moins une grandeur électrique selon l'une quelconque des revendications 6 à 9, dans lequel le module auxiliaire (2) est identifié par son usage.

11. Dispositif de mesure d'au moins une grandeur électrique selon l'une quelconque des revendications 1 à 10, dans lequel le module auxiliaire (2) précité comporte des moyens de guidage (18) de câbles (4) permettant de faciliter le positionnement de ces câbles (4) à l'intérieur dudit module auxiliaire (2), ces câbles véhiculant le courant dans l'appareil à mesurer.

12. Dispositif de mesure d'au moins une grandeur électrique selon l'une quelconque des revendications précédentes, dans lequel le module auxiliaire (2) précité comporte des moyens d'indication (17) de l'état de service du dispositif de mesure B,C.

13. Dispositif de mesure d'au moins une grandeur électrique selon l'une quelconque des revendications précédentes, dans lequel le module auxiliaire (2) comporte des contacts électriques (15) montés en translation et/ou en rotation par rapport audit module auxiliaire (2) de manière à s'adapter à différentes configurations de bornes (6) de l'appareil à mesurer (D).

14. Dispositif de mesure d'au moins une grandeur électrique selon l'une quelconque des revendications précédentes, dans lequel les moyens de raccordement précités (5) comportent des éléments rigides (16) aptes à être raccordés électriquement aux bornes (6) de l'appareil à mesurer D en un seul mouvement.

15. Dispositif de mesure d'au moins une grandeur électrique selon l'une quelconque des revendications 1 à 13, dans lequel les moyens de raccordement précités (5) comportent des câbles de raccordement (20) aux bornes (6) de l'appareil à mesurer (D).

16. Dispositif de mesure d'au moins une grandeur électrique selon l'une quelconque des revendications précédentes, dans lequel le module auxiliaire précité (2) est utilisé comme un module additionnel (21) monté sur un dispositif de mesure du type monobloc classique A utilisé comme un module dit principal (1).

17. Dispositif de mesure d'au moins une grandeur électrique selon l'une quelconque des revendications précédentes, dans lequel le module principal (1) est équipé de bornes de raccordement (25) adaptées à la configuration du tableau électrique dans lequel le dispositif de mesure de l'énergie est destiné à être monté.

18. Dispositif de mesure d'au moins une grandeur électrique selon l'une quelconque des revendications précédentes, comportant des moyens de codage prévus entre les deux modules (1,2) permettant d'empêcher les mauvaises associations entre les deux modules.

19. Dispositif de mesure d'au moins une grandeur électrique selon l'une quelconque des revendications 6 à 18, comportant un micrologiciel permettant d'établir le comportement correspondant à la configuration du produit constitué par l'association des deux modules (1,2).

20. Dispositif de mesure d'au moins une grandeur électrique selon les revendications 1 et 4, dans lequel le premier module (1) est placé derrière le rail oubien à l'intérieur d'un conduit de câbles latéral oubien à l'intérieur d'un conduit de câbles horizontal.

21. Dispositif de mesure d'au moins une grandeur électrique selon l'une quelconque des revendications précédentes, dans lequel le module auxiliaire (2) se présente sous la forme d'une plaque dite d'adaptation (F) comportant des moyens de raccordement (5) adaptés aux bornes de raccordement (6) de l'appareil à mesurer (D).

22. Dispositif de mesure d'au moins une grandeur électrique selon l'une quelconque des revendications précédentes, dans lequel l'appareil est un appareil de protection électrique.

23. Dispositif de mesure d'au moins une grandeur électrique selon l'une quelconque des revendications précédentes, dans lequel le dispositif est un dispositif de mesure de l'énergie électrique traversant au moins un appareil électrique.

## Patentansprüche

1. Vorrichtung zum Messen mindestens einer elektrischen Größe eines Stroms, der in mindestens einem an einer Montagehalterung montierten elektrischen Gerät fließt, umfassend Stromversorgungsmittel, Mittel zum Messen des in dem Gerät fließenden Stroms, Mittel zum Abgreifen der Spannung an den Klemmen des Geräts und Mittel zum Messen dieser Spannung, Mittel zum Verarbeiten der Messinformation und Mittel zum Übermitteln der Messinformationen an einen Empfänger,
**dadurch gekennzeichnet, dass** sie ein erstes Modul (1) umfasst, Hauptmodul genannt, das die vorgenannten Versorgungsmittel, Mittel zum Messen des Stroms und der Spannung, Verarbeitungsmittel und Übermittlungsmittel beinhaltet, und ein zweites Modul, Hilfsmodul (2) genannt, das die Mittel zum Abgreifen der Spannung (p) und Mittel zum elektrischen Verbinden (c) mit dem Hauptmodul (1) beinhaltet, wobei diese Verbindung die Spannungsversorgung des Hauptmoduls (1) und das Messen der vom Hilfsmodul (2) erfassten Spannung ermöglicht, wobei das zweite Modul (2) Mittel zum elektrischen Anschließen (5) an die Klemmen (6) des zu messenden Geräts (D) beinhaltet, wobei diese Mittel (5) an die Konfiguration dieser Klemmen (6) angepasst sind.

2. Vorrichtung zum Messen mindestens einer elektrischen Größe nach Anspruch 1, bei der die vorgenannten Übermittlungsmittel drahtlose Übermittlungsmittel sind.

3. Vorrichtung zum Messen mindestens einer elektrischen Größe nach Anspruch 1 oder 2, bei der die vorgenannten Verbindungsmittel (c) elektrische Kontaktstücke (26, 27) und (28, 29) umfassen, die an den beiden einander gegenüberliegenden Anschlussflächen (a, b) vorgesehen sind, die jeweils zu den beiden Modulen (1, 2) gehören.

4. Vorrichtung zum Messen mindestens einer elektrischen Größe nach Anspruch 1 oder 2, bei der die vorgenannten elektrischen Verbindungsmittel (c) von dem Typ sind, der es den beiden Modulen (1, 2) ermöglicht, voneinander entfernt verwendet zu werden.

5. Vorrichtung zum Messen mindestens einer elektrischen Größe nach Anspruch 4, bei der die vorgenannten Verbindungsmittel (c) Stromkabel (19) umfassen.

6. Vorrichtung zum Messen mindestens einer elektrischen Größe nach einem der Ansprüche 1 bis 5, die Identifikationsmittel zur Identifikation (31, 32) der beiden Module (1, 2) umfasst, wobei die Kombination der Identifikationsmittel (31, 32) der beiden Module (1, 2) es ermöglicht, die Konfiguration des durch das Zusammenstecken der beiden Module (1, 2) gebildeten Produkts auszuführen.

7. Vorrichtung zum Messen mindestens einer elektrischen Größe nach Anspruch 6, bei der die Identifikationsmittel (31, 32) elektrische Kontaktstücke umfassen, die auf den beiden gegenüberliegenden Flächen (a, b) vorgesehen sind, die jeweils zu den beiden Modulen (1, 2) gehören, wobei diese Kontaktstücke mit einem Übermittlungsbus verbunden sind, der das Senden eines Identifikationsrahmens ermöglicht, der die Konfiguration zwischen den beiden Modulen ermöglicht.

8. Vorrichtung zum Messen mindestens einer elektrischen Größe nach Anspruch 6, bei der die Identifikationsmittel (31, 32) Funkverbindungsmittel oder optische Verbindungsmittel zwischen den beiden Modulen (1, 2) umfassen, die das Senden eines Identifikationsrahmens ermöglichen, der die Konfiguration zwischen den beiden Modulen (1, 2) ermöglicht.

9. Vorrichtung zum Messen mindestens einer elektrischen Größe nach einem der Ansprüche 6 bis 8, bei der das Hauptmodul (1) durch eines der Merkmale identifiziert wird, die in der Gruppe enthalten sind, die den Phasentyp, das Kaliber, die Form des Produkts umfasst.

10. Vorrichtung zum Messen mindestens einer elektrischen Größe nach einem der Ansprüche 6 bis 9, bei der das Hilfsmodul (2) durch seine Verwendung identifiziert wird.

11. Vorrichtung zum Messen mindestens einer elektrischen Größe nach einem der Ansprüche 1 bis 10, bei der das vorgenannte Hilfsmodul (2) Führungsmittel (18) zum Führen von Kabeln (4) umfasst, die es ermöglichen, die Positionierung dieser Kabel (4) im Innern des Hilfsmoduls (2) zu erleichtern, wobei diese Kabel den Strom in das zu messende Gerät transportieren.

12. Vorrichtung zum Messen mindestens einer elektrischen Größe nach einem der vorhergehenden Ansprüche, bei der das vorgenannte Hilfsmodul (2) Anzeigemittel (17) zum Anzeigen des Betriebszustands der Messvorrichtung B, C umfasst.

13. Vorrichtung zum Messen mindestens einer elektrischen Größe nach einem der vorhergehenden Ansprüche, bei der das Hilfsmodul (2) elektrische Kontakte (15) umfasst, die in Bezug auf das Hilfsmodul (2) verschiebbar und/oder drehbar gelagert sind, so dass sie sich an verschiedene Klemmenkonfigurationen (6) des zu messenden Geräts (D) anpassen.

14. Vorrichtung zum Messen mindestens einer elektrischen Größe nach einem der vorhergehenden Ansprüche, bei der die vorgenannten Anschlussmittel (5) starre Elemente (16) umfassen, die geeignet sind, mit einer einzigen Bewegung elektrisch an die Klemmen (6) des zu messenden Geräts angeschlossen zu werden.

15. Vorrichtung zum Messen mindestens einer elektrischen Größe nach einem der Ansprüche 1 bis 13, bei der die vorgenannten Anschlussmittel (5) Anschlusskabel (20) zum Anschließen an die Klemmen (6) des zu messenden Geräts (D) umfassen.

16. Vorrichtung zum Messen mindestens einer elektrischen Größe nach einem der vorhergehenden Ansprüche, bei der das vorgenannte Hilfsmodul (2) als ein Zusatzmodul (21) verwendet wird, das an einer Vorrichtung zum Messen vom klassischen einstückigen Typ A montiert ist, die als ein Hauptmodul (1) verwendet wird.

17. Vorrichtung zum Messen mindestens einer elektrischen Größe nach einem der vorhergehenden Ansprüche, bei der das Hauptmodul (1) mit Anschlussklemmen (25) ausgestattet ist, die an die Konfiguration der Schalttafel angepasst sind, in der die Vorrichtung zum Messen der Energie montiert werden soll.

18. Vorrichtung zum Messen mindestens einer elektrischen Größe nach einem der vorhergehenden Ansprüche mit zwischen den beiden Modulen (1, 2) vorgesehenen die Codierungsmitteln, die es ermöglichen, Fehlsteckungen zwischen den beiden Modulen zu vermeiden.

19. Vorrichtung zum Messen mindestens einer elektrischen Größe nach einem der Ansprüche 6 bis 18 mit einer Firmware, die es ermöglicht, das Verhalten herzustellen, das der Konfiguration des durch das Zusammenstecken der beiden Module (1, 2) gebildeten Produkts entspricht.

20. Vorrichtung zum Messen mindestens einer elektrischen Größe nach den Ansprüchen 1 und 4, bei der das erste Modul (1) hinter der Schiene oder aber im Innern eines seitlichen Kabelkanals oder aber im Innern eines waagerechten Kabelkanals angeordnet ist.

21. Vorrichtung zum Messen mindestens einer elektrischen Größe nach einem der vorhergehenden Ansprüche, bei der das Hilfsmodul (2) in Form einer Platte, Adapterplatte (F) genannt, vorliegt, die Anschlussmittel (5) umfasst, die an die Anschlussklemmen (6) des zu messenden Geräts (D) angepasst sind.

22. Vorrichtung zum Messen mindestens einer elektrischen Größe nach einem der vorhergehenden Ansprüche, bei der das Gerät ein elektrisches Schutzgerät ist.

23. Vorrichtung zum Messen mindestens einer elektrischen Größe nach einem der vorhergehenden Ansprüche, bei der die Vorrichtung eine Vorrichtung zum Messen der elektrischen Energie ist, die durch mindestens ein elektrisches Gerät fließt.

## Claims

1. System for measuring at least one electrical quantity of a current circulating in at least one electrical device mounted on a mounting support, comprising electrical power supply means, means for measuring the current circulating in the device, means for tapping the voltage at the terminals of the device, and means for measuring this voltage, means for processing the measurement information, and means for communicating the measurement information to a receiver,
**characterized in that** it comprises a first, so-called main module (1) comprising the abovementioned power supply means, the current and voltage measurement means, the processing means and the communication means, and a second, so-called auxiliary module (2) comprising the voltage tapping means (p) and electrical connection means (c) connecting with the so-called main module (1), this connection allowing voltage to be supplied to the main module (1) and the voltage recorded by the auxiliary module (2) to be measured, the second module (2) comprising electrical coupling means (5) connecting to the terminals (6) of the device to be measured (D), these means (5) being adapted to the configuration of these terminals (6).

2. System for measuring at least one electrical quantity according to Claim 1, wherein the abovementioned communication means are wireless communication means.

3. System for measuring at least one electrical quantity according to Claim 1 or 2, wherein the abovementioned connection means (c) comprise electrical contact pads (26, 27) and (28, 29) provided on the two coupling faces (a, b) facing one another belonging respectively to the two modules (1, 2).

4. System for measuring at least one electrical quantity according to Claim 1 or 2, wherein the abovementioned electrical connection means (c) are of the type allowing the two modules (1, 2) to be used by being separated from one another.

5. System for measuring at least one electrical quantity according to Claim 4, wherein the abovementioned connection means (c) comprise electrical cables (19).

6. System for measuring at least one electrical quantity according to any one of Claims 1 to 5, comprising means (31, 32) for identifying the two modules (1, 2), the combination of the means (31, 32) for identifying the two modules (1, 2) making it possible to produce the configuration of the product consisting of the association of the two modules (1, 2).

7. System for measuring at least one electrical quantity according to Claim 6, wherein the identification means (31, 32) comprise electrical contact pads provided on the two facing faces (a, b) belonging respectively to the two modules (1, 2), these contact pads being connected to a communication bus making it possible to send an identification frame allowing the configuration between the two modules.

8. System for measuring at least one electrical quantity according to Claim 6, wherein the identification means (31, 32) comprise RF or optical link means between the two modules (1, 2) making it possible to send an identification frame allowing the configuration between the two modules (1, 2).

9. System for measuring at least one electrical quantity according to any one of Claims 6 to 8, wherein the main module (1) is identified by one of the characteristics contained in the group comprising the type of phase, the rating, and the form of the product.

10. System for measuring at least one electrical quantity according to any one of Claims 6 to 9, wherein the auxiliary module (2) is identified by the usage thereof.

11. System for measuring at least one electrical quantity according to any one of Claims 1 to 10, wherein the abovementioned auxiliary module (2) comprises guiding means (18) for cables (4) making it possible to facilitate the positioning of these cables (4) inside said auxiliary module (2), these cables conveying the current in the device to be measured.

12. System for measuring at least one electrical quantity according to any one of the preceding claims, wherein the abovementioned auxiliary module (2) comprises means (17) for indicating the service status of the measurement system B, C.

13. System for measuring at least one electrical quantity according to any one of the preceding claims, wherein the auxiliary module (2) comprises electrical contacts (15) mounted to translate and/or rotate relative to said auxiliary module (2) so as to adapt to different configurations of terminals (6) of the device to be measured (D).

14. System for measuring at least one electrical quantity according to any one of the preceding claims, wherein the abovementioned coupling means (5) comprise rigid elements (16) capable of being coupled electrically to the terminals (6) of the device to be measured D in a single movement.

15. System for measuring at least one electrical quantity according to any one of Claims 1 to 13, wherein the abovementioned coupling means (5) comprise coupling cables (20) connecting to the terminals (6) of the device to be measured (D).

16. System for measuring at least one electrical quantity according to any one of the preceding claims, wherein the abovementioned auxiliary module (2) is used as an add-on module (21) mounted on a measurement system of conventional one-piece type A used as a so-called main module (1).

17. System for measuring at least one electrical quantity according to any one of the preceding claims, wherein the main module (1) is equipped with coupling terminals (25) adapted to the configuration of the electrical switchboard wherein the energy measurement system is intended to be mounted.

18. System for measuring at least one electrical quantity according to any one of the preceding claims, comprising coding means provided between the two modules (1, 2) making it possible to prevent wrong associations between the two modules.

19. System for measuring at least one electrical quantity according to any one of Claims 6 to 18, comprising firmware making it possible to establish the behaviour corresponding to the configuration of the product consisting of the association of the two modules (1, 2).

20. System for measuring at least one electrical quantity according to Claims 1 and 4, wherein the first module (1) is placed behind the rail or else inside a lateral cable duct or else inside a horizontal cable duct.

21. System for measuring at least one electrical quantity according to any one of the preceding claims, wherein the auxiliary module (2) takes the form of a so-called adaptation plate (F) comprising coupling means (5) adapted to the coupling terminals (6) of the device to be measured (D).

22. System for measuring at least one electrical quantity according to any one of the preceding claims, wherein the device is an electrical protection device.

23. System for measuring at least one electrical quantity according to any one of the preceding claims, wherein the system is a system for measuring the electrical energy passing through at least one electrical device.
